# EUROPÄISCHE PATENTANMELDUNG

(11) **EP 2 549 845 A2**
(43) Veröffentlichungstag der Anmeldung: **23.01.2013**
(21) Anmeldenummer: 12178648.7
(22) Anmeldetag: 31.07.2012
(51) Int. Cl.: H05K 7/18, H02B 1/04

(54) **Schaltschrank für ein Pitchsystem**

(71) Anmelder: Moog Unna GmbH, 59423 Unna (DE)
(72) Erfinder: Springauf, Michael, 33165 Lichtenau (DE); Franzak, Bernd, 44534 Lünen (DE)
(74) Vertreter: Jostarndt, Hans-Dieter

(57) **Zusammenfassung**

Beschrieben und dargestellt ist einen Schaltschrank (1) für ein Pitchsystem mit einem Gehäusekörper (2), elektrischen Einrichtungen (3) und einem äußeren Tragwerk (4), wobei das äußere Tragwerk (4) außerhalb des Gehäusekörpers (2) angeordnet ist.

Ein Schaltschrank (1) für ein Pitchsystem, der einfach und materialsparend herzustellen ist, wird erfindungsgemäß dadurch realisiert, dass der Schaltschrank (1) ein inneres Tragwerk (5) und wenigstens ein Tragwerkverbindungsmittel (6) aufweist, wobei das innere Tragwerk (5) innerhalb des Gehäusekörpers (2) angeordnet ist, das eine oder die mehreren Tragwerkverbindungsmittel (6) die Wandung (7) des Gehäusekörpers (2) durchdringen, das eine oder die mehreren Tragwerkverbindungsmittel (6) das innere Tragwerk (5) mit dem äußeren Tragwerk (4) verbinden und die elektrischen Einrichtungen (3) an dem inneren Tragwerk (5) befestigt sind.

## Beschreibung

Die Erfindung betrifft einen Schaltschrank für ein Pitchsystem mit einem Gehäusekörper, elektrischen Einrichtungen und einem äußeren Tragwerk, wobei das äußere Tragwerk außerhalb des Gehäusekörpers angeordnet ist.

Elektrische Einrichtungen in Windenergieanlagen sind extremen klimatischen Bedingungen und starken mechanischen Belastungen ausgesetzt. Aus diesem Grund werden insbesondere die elektrischen Einrichtungen, die sich in den rotierenden Teilen einer Windenergieanlage befinden, wie z. B. der Nabe, in einem oder mehreren Schaltschränken angeordnet. Insbesondere in der Nabe einer Windenergieanlage können Fremdkörper, die durch die ständige Rotation der Nabe bewegt werden, die elektrischen Einrichtungen beschädigen. Zum Schutz der elektrischen Einrichtungen vor den klimatischen Bedingungen, wie z. B. übermäßige Kälte und Hitze, weisen derartige Schaltschränke häufig auch eine Heiz- und/oder Kühleinrichtung auf. Im Offshoreeinsatz müssen die elektrischen Einrichtungen ebenso vor salzhaltigem Sprühnebel geschützt werden, was durch eine entsprechende Abdichtung der Schaltschränke erreicht wird. Zudem werden die Schaltschränke zum Schutz vor Korrosion aus einem wenig oder nicht korrodierenden Material, wie z. B. Edelstahl, gefertigt. Um die Wartbarkeit der elektrischen Einrichtungen zu gewährleisten sind die Schaltschränke in der Regel mit einer Öffnung versehen, die mit einem Deckel lösbar verschlossen ist. Nach Öffnung des Deckels hat das Wartungspersonal durch die Öffnung Zugang zu den elektrischen Einrichtungen und kann diese z. B. austauschen oder reparieren.

Aus der DE 102010060912 A1 ist ein Schaltschrank einer Windkraftanlage bekannt, der modular aufgebaute Montageplatten in Form einer Bodenplatte und mehrerer Seitenwände umfasst, wobei ein durch die Montageplatten gebildeter, einen Innenraum begrenzender Schrankkörper eine umlaufende, aus den Seitenwänden gebildete Wandung aufweist und an den nach innen gerichteten Seiten der Montageplatten elektrische Einrichtungen angeordnet sind, wobei eine Haube eine Ummantelung der Wandung des Schrankkörpers bildet.

Die DE 102010034873 A1 offenbart einen mit einem Deckel verschlossenen kastenförmigen elektrischen Schaltschrank zur Aufnahme von elektrischen Komponenten und Geräte für einen Blattwinkelverstellantrieb einer Windenergieanlage, mittels welchem ein oder mehrere Rotorblätter der Anlage um ihre Blattachsen drehbar sind, wobei der Schaltschrank aus mindestens zwei Modulen bzw. Schaltschranksegmenten zusammengesetzt ist, und jeweils einem Modul funktionsmäßig bestimmte elektrische Komponenten zugeordnet sind, wobei einem Segment bzw. Modul jeweils unterschiedliche elektrische Komponenten und Geräte zugeordnet werden können bzw. zuordbar sind, mit denen - als Teilfunktion kombiniert - unterschiedliche Gesamtfunktionen bzw. Ausführungsformen des Schaltschrankes realisiert werden können bzw. realisierbar sind.

Um die aus dem Stand der Technik bekannten Schaltschränke innerhalb der Windenergieanlage zu befestigen werden üblicherweise Stahlträger außen auf die Wandung des Gehäusekörpers aufgeschweißt und diese Stahlträger mit gängigen Befestigungsmitteln, wie z. B. Schrauben, an geeigneten Tragstrukturen innerhalb der Windenergieanlage befestigt. Diese Vorgehensweise bringt erhebliche Nachteile mit sich. Zunächst kann es beim Schweißvorgang zu einem Verzug der Geometrie der miteinander verschweißten Teile und daraus resultierenden Spannungen kommen. Der eigentliche Schweißprozess wiederum kann Gefüge- und Legierungsänderungen im Bereich der Schweißnaht hervorrufen, die den Korrosionswiderstand der verschweißten Teile herabsetzen können. Darüber hinaus ist der Schweißprozess mit einem erheblichen Aufwand verbunden. Es stellen sich hohe Anforderungen an das Fachpersonal, das die Schweißung durchführt. Die zu verschweißenden Teile müssen vorbehandelt und die Schweißnähte nachbehandelt werden. Ferner ist die Qualitätskontrolle der Schweißnähte schwierig durchzuführen und erfordert einen hohen technischen Aufwand. Erschwerend kommt hinzu, dass häufig die Wandung des Gehäusekörpers eine geringere Dicke aufweist, als die aufzuschweißenden Stahlträger. Dieser Dickenunterschied verschärft die zuvor aufgeführten Nachteile des Schweißprozesses enorm. Um trotzdem die Stabilität des Schaltschrankes und seiner Befestigung innerhalb der Windenergieanlage zu gewährleisten, werden in der Regel für die Auslegung sowohl des Gehäusekörpers als auch der Stahlträger entsprechende Sicherheitsaufschläge berücksichtigt, was bedeutet, dass sich der Materialaufwand für den Gehäusekörper und die Stahlträger erhöht.

Damit ist es die Aufgabe der Erfindung, einen Schaltschrank für ein Pitchsystem anzugeben, der einfach und materialsparend herzustellen ist.

Die zuvor hergeleitete und aufgezeigte Aufgabe ist ausgehend von dem eingangs beschriebenen Schaltschrank für ein Pitchsystem dadurch gelöst, dass der Schaltschrank ein inneres Tragwerk und wenigstens ein Tragwerkverbindungsmittel aufweist, wobei das innere Tragwerk innerhalb des Gehäusekörpers angeordnet ist, das eine oder die mehreren Tragwerkverbindungsmittel die Wandung des Gehäusekörpers durchdringen, das eine oder die mehreren Tragwerkverbindungsmittel das innere Tragwerk mit dem äußeren Tragwerk verbinden und die elektrischen Einrichtungen an dem inneren Tragwerk befestigt sind.

Das eine oder die mehreren Tragwerkverbindungsmittel umfassen sowohl lösbare als auch nicht lösbare Tragwerkverbindungsmittel z. B. Schrauben, Nieten oder Schließringbolzen. Das eine oder die mehreren Tragwerkverbindungsmitteln verbinden das äußere Tragwerk und das innere Tragwerk derart miteinander, dass die auf das innere Tragwerk wirkenden Kräfte, wie z. B. die durch das innere Tragwerk selbst und die an dem inneren Tragwerk befestigten elektrischen Einrichtungen verursachten Gewichts- und Zentrifugalkräfte, zuverlässig auf das äußere Tragwerk übertragen werden. Im Gegensatz zum Stand der Technik wird hierdurch erreicht, dass die auftretenden Kräfte nicht über den Gehäusekörper, sondern im Wesentlichen über das eine oder die mehreren Tragwerkverbindungsmittel auf das äußere Tragwerk übertragen werden. Die Ausgestaltung des inneren Tragwerks ist derart gewählt, dass das innere Tragwerk die auftretenden Kräfte auf das eine oder die mehreren Tragwerkverbindungsmittel übertragen kann.

Die Ausgestaltung des äußeren Tragwerks ist derart gewählt, dass das äußere Tragwerk die von dem inneren Tragwerk auf das Tragwerkverbindungsmittel übertragenen Kräfte aufnehmen und an geeignete Tragstrukturen innerhalb der Windenergieanlage übertragen kann. Die von dem Gehäusekörper ausgehenden Gewichts- und Zentrifugalkräfte werden mittelbar über das eine oder die mehreren Tragwerkverbindungsmittel und/oder unmittelbar auf das äußere Tragwerk übertragen. Da der Gehäusekörper nicht mehr diese Kräfte übertragen muss, ist es möglich die Materialstärke des Gehäusekörpers zu reduzieren und auf diese Weise die Materialkosten zu reduzieren. Als Material für den Gehäusekörper, das innere Tragwerk und das äußerer Tragwerk wird vorzugsweise Edelstahl mit einem hohen Korrosionswiderstand verwendet. Ebenso ist es auch denkbar z. B. Kunststoffe, andere Metalle und faserverstärkte Verbundmaterialen auf der Basis von Glasfasern und/oder Kohlenstofffasern zu verwenden.

Der erfindungsgemäße Schaltschrank wird vorzugsweise in einem rotierenden Teil einer Windenergieanlage angeordnet. Besonders bevorzugt in der Nabe einer Windenergieanlage. Innerhalb des Schaltschranks können Teile der elektrischen Komponenten eines Pitchsystems angeordnet sein. Bevorzugt sind die elektrischen Komponenten des Pitchsystems auf eine Mehrzahl an Schaltschränken verteilt. Insbesondere können in einem erfindungsgemäßen Schaltschrank die Notenergiespeicher eines Pitchsystems sowie eine übergeordnete Steuerungseinheit eines Pitchsystems angeordnet werden.

Gemäß einer vorteilhaften Weiterbildung der Erfindung ist vorgesehen, dass die Wandung des Gehäusekörpers zwischen innerem Tragwerk und äußerem Tragwerk eingeklemmt ist. Erfindungsgemäß werden das innere Tragwerk und das äußere Tragwerk durch das eine oder die mehreren Tragwerkverbindungsmittel derart miteinander verbunden, dass aus der Verbindung eine Kraft resultiert, die das innere Tragwerk und das äußere Tragwerk zusammenpresst, wodurch die zwischen dem inneren Tragwerk und dem äußeren Tragwerk angeordnete Wandung des Gehäusekörpers zwischen diesen eingeklemmt wird. Durch diese kraftschlüssige Verbindung können die von dem Gehäusekörper ausgehenden Gewichts- und Zentrifugalkräfte sowohl mittelbar über das eine oder die mehreren Tragwerkverbindungsmittel als auch unmittelbar auf das äußere Tragwerk übertragen werden.

Eine vorteilhafte Ausgestaltung der Erfindung zeichnet sich dadurch aus, dass das innere Tragwerk wenigstens eine Montageplatte aufweist, wobei die elektrischen Einrichtungen mittelbar oder unmittelbar an der einen oder den mehreren Montageplatten befestigt sind. Die Verwendung von einer oder mehreren Montageplatten vereinfacht die Herstellung des erfindungsgemäßen Schaltschrankes enorm. Während des Herstellungsprozesses werden die eine oder die mehreren Montageplatten separat mit den elektrischen Einrichtungen bestückt. Dadurch, dass sich die eine oder die mehreren Montageplatten hierbei außerhalb des Gehäusekörpers befinden, sind die eine oder die mehreren Montageplatten besonders gut zugänglich und handhabbar. Auf diese Weise könne die fertig auf der einen oder den mehreren Montageplatten befestigten elektrischen Einrichtungen, sowohl im Zusammenspiel untereinander als auch einzeln, problemlos getestet und bei Bedarf repariert oder ersetzt werden. Erst darauf werden die eine oder die mehreren Montageplatten in den Gehäusekörper eingesetzt.

Die elektrischen Einrichtungen umfassen hierbei insbesondere elektrische Bauteile wie z. B. Widerstände, Drosseln und Schaltschütze als auch integrierte elektronische Schaltungen oder elektrische Geräte. Der Ausdruck "elektrisch" umfasst somit auch den Ausdruck "elektronisch" und ist insbesondere durch den Ausdruck "elektrisch und/oder elektronisch" ersetzbar. Vorzugsweise sind an der einen oder den mehreren Montageplatten Halter und/oder Befestigungseinrichtungen vorgesehen. An diesen Haltern und/oder Befestigungseinrichtungen können die elektrischen Einrichtungen vorzugsweise lösbar befestigt werden. Ebenso können in den Schaltschränken Notenergiespeicher, wie z. B. Akkumulatoren oder Kondensatoren, insbesondere so genannte Ultracaps, angeordnet sein. Diese Notenergiespeicher dienen der Energieversorgung des Pitchsystems in dem Fall eines Netzausfalls.

Bei einer bevorzugten Ausgestaltung der Erfindung ist vorgesehen, dass wenigstens um den Bereich der einen oder wenigstens einer der mehreren Durchdringungen der Wandung des Gehäusekörpers jeweils eine Dichtung zwischen dem äußeren Tragwerk und der Wandung des Gehäusekörpers angeordnet ist. Als Durchdringungen werden hierbei die Stellen bezeichnet, an denen der Gehäusekörper von dem einen oder den mehreren Tragwerkverbindungsmitteln durchdrungen wird. Insbesondere kann diese Dichtung durch eine ringförmige Unterlegscheibe aus einem Dichtmaterial gebildet werden. Ferner ist es bevorzugt alternativ oder zusätzlich zu der oder den Dichtungen zwischen dem äußeren Tragwerk und der Wandung des Gehäusekörpers, dass wenigstens um den Bereich der einen oder wenigstens einer der mehreren Durchdringungen der Wandung des Gehäusekörpers jeweils eine Dichtung zwischen dem äußeren Tragwerk und dem Tragwerkverbindungsmittel angeordnet ist. Hierbei ist die ringförmige Unterlegscheibe bevorzugt unterhalb eines Kopfes des Tragwerkverbindungsmittels angeordnet ist. Durch das Vorsehen einer derartigen Dichtung wird zum einen das Eindringen von Verschmutzungen in den Gehäusekörper verhindert, zum anderen wird hierdurch der Spaltabstand zwischen dem äußeren Tragwerk und dem Gehäusekörper bzw. dem Kopf des Tragwerkverbindungsmittels vergrößert, so dass die Gefahr der Spaltkorrosion gebannt wird.

Gemäß einer besonders vorteilhaften Weiterbildung der Erfindung ist vorgesehen, dass der Schaltschrank wenigstens ein Verbindungsmittel aufweist, wobei das eine oder die mehreren Verbindungsmittel die Wandung des Gehäusekörpers durchdringen und das eine oder die mehreren Verbindungsmittel das innere

Tragwerk mit dem Gehäusekörper verbinden. Je nach Ausgestaltung des inneren Tragwerks und der Anordnung des einen oder der mehreren Tragwerkverbindungsmittel ist es erforderlich mit einem oder mehreren Verbindungsmitteln eine Verbindung zwischen dem inneren Tragwerk und einer Wandung des Gehäusekörpers herzustellen. Hierdurch kann einerseits ein Teil der auftretenden Kräfte vom inneren Tragwerk auf den Gehäusekörper und von diesem wiederum mittelbar und/oder unmittelbar auf das äußere Tragwerk übertragen werden. Andererseits bietet diese Ausgestaltung den Vorteil, dass hierdurch die Wandung des Gehäusekörpers ihrerseits die auftretenden Kräfte auf das innere Tragwerk überträgt und so die Stabilität der Wandung des Gehäusekörpers verbessert wird.

Bei einer bevorzugten Ausgestaltung der Erfindung ist vorgesehen, dass, alternativ oder zusätzlich zu der oder den vorgenannten Dichtungen, wenigstens um den Bereich der einen oder wenigstens einer der mehreren Durchdringungen der Wandung des Gehäusekörpers durch das eine oder die mehreren Verbindungsmittel jeweils eine Dichtung zwischen dem Gehäusekörper und dem jeweiligen Verbindungsmittel angeordnet ist. Insbesondere kann diese Dichtung durch eine ringförmige Unterlegscheibe aus einem Dichtmaterial gebildet werden, wobei die ringförmige Unterlegscheibe unterhalb eines Kopfes des Verbindungsmittels angeordnet ist.

Gemäß einer weiteren bevorzugten Ausgestaltung der Erfindung ist vorgesehen, dass der Schaltschrank eine Öffnung und einen korrespondierenden Deckel aufweist, wobei die Öffnung lösbar mit dem Deckel verschließbar ist. Der Deckel kann insbesondere abnehmbar ausgebildet sein oder über wenigstens ein Scharnier fest mit dem Gehäusekörper verbunden sein. Zu Wartungszwecken sind die innerhalb des Gehäusekörpers angeordneten elektrischen Einrichtungen nach Öffnen des Deckels über die Öffnung zugänglich. Im Betrieb der Windenergieanlage ist die Öffnung durch den Deckel fest verschlossen und die elektrischen Einrichtungen sind vor Umwelteinflüssen und Verunreinigungen geschützt. Darüber hinaus ist es vorteilhaft, wenn das äußere Tragwerk an der Außenseite der der Öffnung gegenüberliegenden Seite des Gehäusekörpers angeordnet ist.

Gemäß einer weiteren bevorzugten Weiterbildung der Erfindung ist vorgesehen, dass zwischen dem inneren Tragwerk und der Wandung des Gehäusekörpers wenigstens ein Innenprofilträger angeordnet ist, wobei der eine oder die mehreren Innenprofilträger an die innere Form der Wandung des Gehäusekörpers angepasst sind.

Bei einer vorteilhaften Ausgestaltung der Erfindung ist vorgesehen, dass das eine oder die mehreren Tragwerkverbindungsmittel den einen oder wenigstens einen der mehreren Innenprofilträger durchdringen und der eine oder die mehreren Innenprofilträger zwischen dem Gehäusekörper und dem inneren Tragwerk eingeklemmt sind.

Erfindungsgemäß werden das innere Tragwerk und das äußere Tragwerk durch das eine oder die mehreren Tragwerkverbindungsmittel derart miteinander verbunden, dass aus der Verbindung eine Kraft resultiert, die das innere Tragwerk und das äußere Tragwerk zusammenpresst, wodurch die zwischen dem inneren Tragwerk und dem äußeren Tragwerk angeordnete Wandung des Gehäusekörpers zwischen diesen eingeklemmt wird. Der eine oder die mehreren Innenprofilträger werden auf die gleiche Weise zwischen dem Gehäusekörper und dem inneren Tragwerk eingeklemmt. Dadurch dass die Innenprofilträger an die innere Form der Wandung angepasst sind und sich an die Wandung anschmiegen, wird die Wandung des Gehäusekörpers stabilisiert. Über diese kraftschlüssige Verbindung können die von dem Gehäusekörper ausgehenden Gewichts- und Zentrifugalkräfte mittelbar über die Innenprofilträger und das eine oder die mehreren Tragwerkverbindungsmittel auf das äußere Tragwerk übertragen werden.

Gemäß einer weiteren vorteilhaften Ausgestaltung der Erfindung ist vorgesehen, dass der eine oder wenigstens einer der mehreren Innenprofilträger ein L-Profil aufweist und jeweils zumindest teilweise entlang einer Innenkante der inneren Wandung des Gehäusekörpers verläuft. Durch diese Ausgestaltung werden die eine oder die mehreren Innenkanten stabilisiert. Insbesondere werden hierdurch Bewegungen des Gehäusekörpers relativ zum inneren Tragwerk und zum äußeren Tragwerk verhindert.

Bei einer besonders vorteilhaften Ausgestaltung der Erfindung ist vorgesehen, dass das äußere Tragwerk wenigstens zwei Profilträger aufweist. Vorzugsweise weist wenigstens einer der Profilträger eine derartige Länge auf, dass wenigstens ein Ende des Profilträgers den Gehäusekörper seitlich überragt. Mit diesem einen oder den mehreren Enden können der eine oder die mehreren Profilträger an geeigneten Tragstrukturen innerhalb der Windenergieanlage befestigt werden. Im Rahmen der Erfindung ist es ebenfalls möglich, dass mehrere Gehäusekörper auf einem äußeren Tragwerk befestigt sind. Prinzipiell ist es ebenso möglich, dass das äußere Tragwerk lediglich einen Profilträger aufweist, wobei aus Stabilitätsgründen zwei Profilträger vorteilhaft sind. Vorzugsweise verlaufen der eine oder die mehreren Profilträger im Wesentlichen parallel zu dem einen oder den mehreren Innenprofilträgern.

Bei einer vorteilhaften Weiterbildung der Erfindung ist vorgesehen, dass das innere Tragwerk wenigstens eine Querstrebe aufweist, wobei die eine oder wenigstens eine der mehreren Querstreben mit wenigstens zwei der Profilträger über das eine oder wenigstens eines der mehreren Tragwerkverbindungsmittel verbunden ist. Durch diese Art der Querverbindung der wenigstens zwei Profilträger über den wenigstens einen oder die mehreren Querstreben wird die Steifigkeit der Gesamtkonstruktion, bestehend aus innerem Tragwerk und äußerem Tragwerk, deutlich erhöht. Gemäß einer weiteren vorteilhaften Weiterbildung der Erfindung ist vorgesehen, dass wenigstens zwei der Profilträger im Wesentlichen parallel zueinander verlaufen. Im Rahmen der Erfindung hat es sich als vorteilhaft herausgestellt, wenn wenigstens zwei der Profilträger im Wesentlichen senkrecht zueinander verlaufen. Hierbei können die wenigstens zwei Profilträger insbesondere zu einer T-förmigen Konstruktion verbunden sein. Bei dieser vorteilhaften Ausgestaltung überragen bei entsprechender Länge die zwei Profilträger den Gehäusekörper mit drei ihrer Enden und es ergeben sich hierdurch folglich drei bevorzugte Befestigungsmöglichkeiten der Profilträger an geeigneten Tragstrukturen innerhalb der Windenergieanlage.

Gemäß einer bevorzugten Ausgestaltung der Erfindung ist vorgesehen, dass die Formen der Profilträger des äußeren Tragwerks ausgewählt sind aus der Gruppe bestehend aus 1-Profil, L-Profil, T-Profil, U-Profil und Z-Profil. Je nach Ausgestaltung des Gehäusekörpers und der Tragstrukturen innerhalb der Windenergieanlage erweisen sich bestimmte Profilformen als voreilhaft. Generell ist die Profilform jedoch nicht auf eine bestimmte Form beschränkt. Es können sowohl aus dem Stand der Technik bekannte Profilformen Verwendung finden als auch speziell an die Anforderungen und Gegebenheiten in einer Windenergieanlage angepasste Profilformen.

Im Einzelnen gibt es nun eine Vielzahl von Möglichkeiten, den erfindungsgemäßen Schaltschrank für ein Pitchsystem auszugestalten und weiterzubilden. Dazu wird auf die dem Patentanspruch 1 nachgeordneten Patentansprüche sowie auf die nachfolgende detaillierte Beschreibung bevorzugter Ausführungsbeispiele der Erfindung unter Bezugnahme auf die Zeichnung verwiesen.

In der Zeichnung zeigt
- Fig. 1: schematisch den erfindungsgemäßen Schaltschrank in einer Schnittdarstellung gemäß einer bevorzugten Weiterbildung der Erfindung,
- Fig. 2: schematisch den erfindungsgemäßen Schaltschrank in einer Draufsicht und
- Fig. 3: schematisch den erfindungsgemäßen Schaltschrank nach einer weiteren Ausgestaltung in einer Rückansicht.

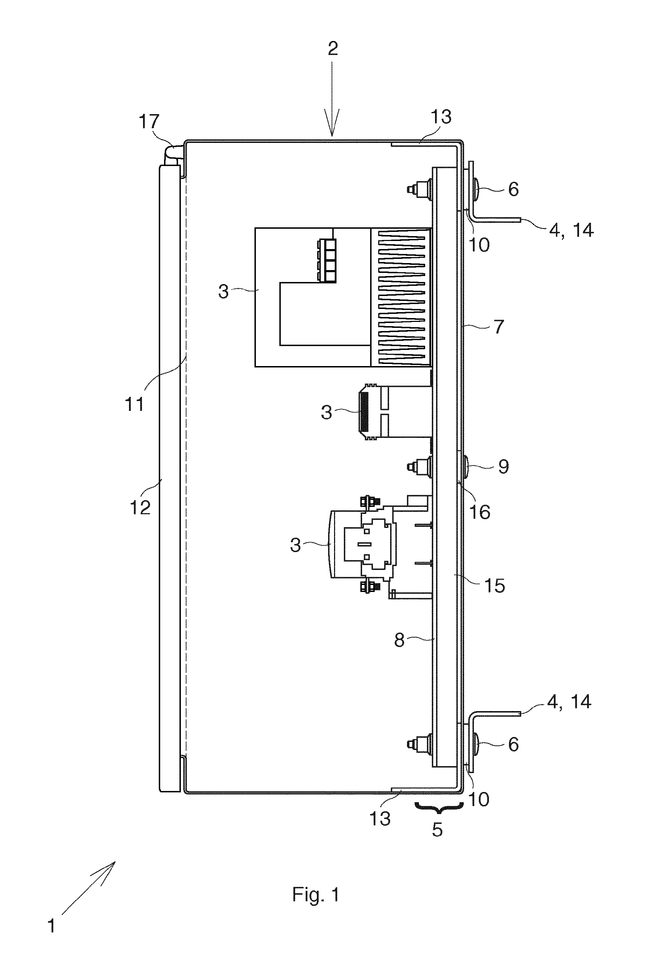

Die Fig. 1 zeigt den erfindungsgemäßen Schaltschrank 1 gemäß einer bevorzugten Weiterbildung der Erfindung mit einem Gehäusekörper 2, elektrischen Einrichtungen 3, einem äußeren Tragwerk 4 und einem inneren Tragwerk 5. Das innere Tragwerk 5 ist über Tragwerkverbindungsmittel 6 mit dem äußeren Tragwerk 4 verbunden. Das Tragwerkverbindungsmittel 6 wird durch Schließringbolzen gebildet. Die Tragwerkverbindungsmittel 6 durchdringen die Wandung 7 des Gehäusekörpers 2. Das innere Tragwerk 5 weist eine Montageplatte 8 auf. An dieser Montageplatte 8 sind die elektrischen Einrichtungen 3 befestigt. Des Weiteren ist ein Verbindungsmittel 9 vorgesehen, welches die Wandung 7 des Gehäusekörpers 2 mit dem inneren Tragwerk 5 verbindet. Im Bereich der Durchdringungen der Wandung 7 des Gehäusekörpers 2 durch die Tragwerkverbindungsmittel 6 sind zwischen dem äußeren Tragwerk 4 und der Wandung 7 des Gehäusekörpers 2 Dichtungen 10 angeordnet. Auf der dem äußeren Tragwerk 4 gegenüberliegenden Seite des Gehäusekörpers 2 ist eine Öffnung 11 angeordnet, die mit einem Deckel 12 verschließbar ist.

Zwischen dem inneren Tragwerk 5 und der Wandung 7 des Gehäusekörpers 2 sind zwei Innenprofilträger 13 angeordnet, die L-förmig ausgebildet sind und sich jeweils entlang einer Innenkante der inneren Wandung 7 des Gehäusekörpers 2 verlaufen. Das äußere Tragwerk 4 weist zwei im Wesentlichen parallel zu den Innenprofilträgern 13 verlaufende, ebenfalls L-förmige, Profilträger 14 auf. Das innere Tragwerk 5 weist mehrere Querstreben 15 auf, von denen in der Schnittdarstellung nur eine sichtbar ist. Die Querstreben 15 verlaufen im Wesentlichen senkrecht zu den Profilträgern 14 des äußeren Tragwerks 4 und sind jeweils über ein Tragwerkverbindungsmittel 6 mit den Profilträgern 14 verbunden. Um das Verbindungsmittel 9 ist zwischen der Querstrebe 15 und der Wandung 7 des Gehäusekörpers 2 ein Abstandshalter 16 angeordnet. Der Abstandshalter 16 entspricht in seiner Dicke in etwa den Innenprofilträgern 13 und verhindert so Biegebelastungen der Querstrebe 15 und der Wandung 7 des Gehäusekörpers 2 beim Spannen des Verbindungsmittels 9. Der Deckel 12 ist mit einem Scharnier 17 an dem Gehäusekörper 2 befestigt.

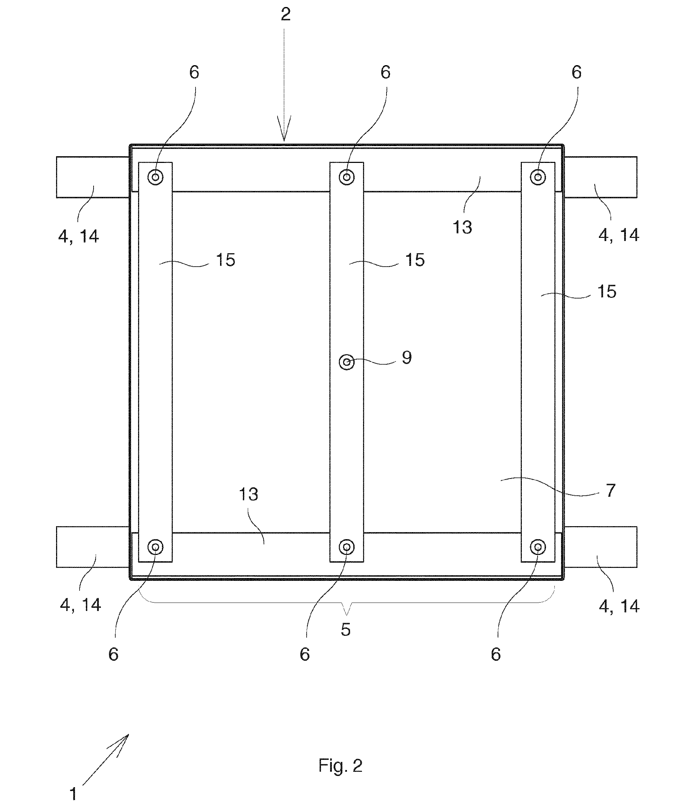

In Fig. 2 ist der erfindungsgemäße Schaltschrank 1 in einer Draufsicht dargestellt. Die Öffnung 11 und der Deckel 12 sind hier zur besseren Übersicht nicht dargestellt. Der Schaltschrank 1 weist einen quaderförmigen Gehäusekörper 2 auf. Innerhalb des Gehäusekörpers 2 ist das innere Tragwerk 5 angeordnet. Das innere Tragwerk 5 weist drei Querstreben 15 auf, die parallel zueinander verlaufen. Ebenfalls nicht dargestellt sind die Montageplatte 8 und die auf der Montageplatte 8 befestigten elektrischen Einrichtungen 3. Auf der Rückseite des Gehäusekörpers 2 ist das äußere Tragwerk 4 angeordnet, welches zwei Profilträger 14 aufweist. Die beiden Profilträger 14 verlaufen parallel zueinander und überragen den Gehäusekörper 2 mit ihren Enden zu beiden Seiten. Diese Enden können dazu verwendet werden den Schaltschrank 1 an geeigneten Tragstrukturen innerhalb der Windenergieanlage zu befestigen. Zwischen der Wandung 7 des Gehäusekörpers 2 und den Querstreben 15 sind zwei Innenprofilträger 13 angeordnet. Die Innenprofilträger 13 weisen im Wesentlichen ein L-förmiges Profil auf und verlaufen entlang der oberen und der unteren Innenkante der inneren Wandung 7 des Gehäusekörpers 2. Hierbei sind die Innenprofilträger 13 derart orientiert, dass sie sich an die innere Form der Wandung 7 des Gehäusekörpers anschmiegen, d. h. eine maximale Berührfläche mit der Wandung 7 aufweisen. Das innere Tragwerk 5 ist über Tragwerkverbindungsmittel 6 mit dem äußeren Tragwerk 4 verbunden. Die Tragwerkverbindungsmittel 6 durchdringen die Innenprofilträger 13 und die Wandung 7 des Gehäusekörpers 2. Die Tragwerkverbindungsmittel 6 sind derart ausgestaltet, dass die Innenprofilträger 13 und die Wandung 7 des Gehäusekörpers 2 zwischen dem inneren Tragwerk 5 und dem äußeren Tragwerk 4 eingeklemmt sind. Über ein Verbindungsmittel 9 ist das innere Tragwerk mit der Wandung 7 des Gehäusekörpers 2 verbunden.

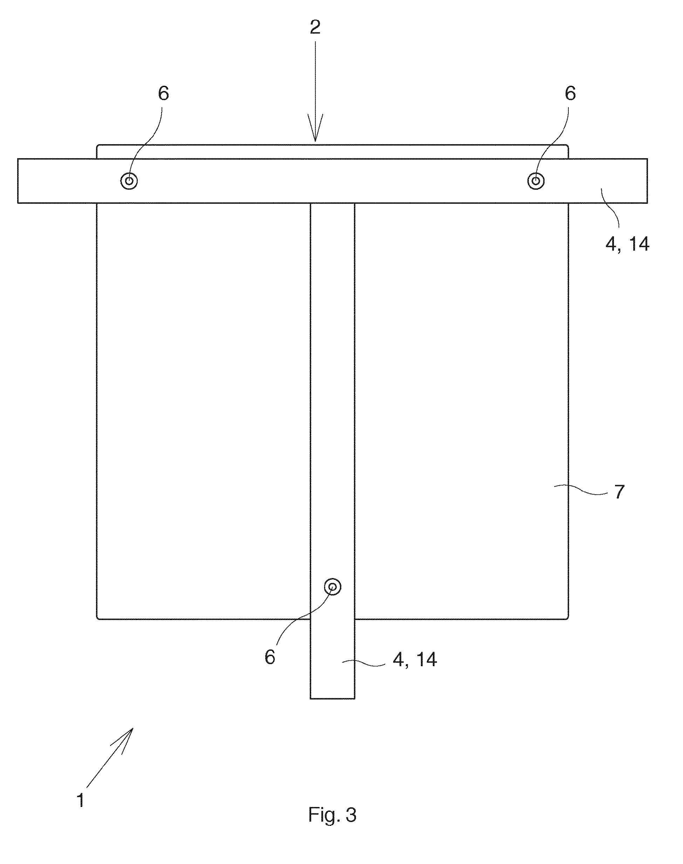

Der Fig. 3 ist ein erfindungsgemäßer Schaltschrank 1 nach einer weiteren Ausgestaltung der Erfindung in einer Rückansicht zu entnehmen. Auf der Rückseite des Gehäusekörpers 2 ist das äußere Tragwerk 4 auf der Wandung 7 des Gehäusekörpers 2 angeordnet. Nach dieser Ausgestaltung weist das äußere Tragwerk 4 zwei Profilträger 14 auf. Die Profilträger 14 sind T-förmig angeordnet und an ihrem Berührungsbereich miteinander verbunden. Diese Verbindung kann z. B. durch Verschweißen oder Verschrauben hergestellt sein. Das äußere Tragwerk 4 ist mit drei Tragwerkverbindungsmitteln 6 mit dem inneren Tragwerk 5 (nicht dargestellt) verbunden.

### Bezugszeichenliste

- 1: Schaltschrank
- 2: Gehäusekörper
- 3: Elektrische Einrichtung
- 4: Äußeres Tragwerk
- 5: Inneres Tragwerk
- 6: Tragwerkverbindungsmittel
- 7: Wandung
- 8: Montageplatte
- 9: Verbindungsmittel
- 10: Dichtung
- 11: Öffnung
- 12: Deckel
- 13: Abstandshalter
- 14: Profilträger
- 15: Querstrebe
- 16: Abstandshalter
- 17: Scharnier

## Patentansprüche

1. Schaltschrank (1) für ein Pitchsystem mit einem Gehäusekörper (2), elektrischen Einrichtungen (3) und einem äußeren Tragwerk (4), wobei das äußere Tragwerk (4) außerhalb des Gehäusekörpers (2) angeordnet ist,
**dadurch gekennzeichnet,**
**dass** der Schaltschrank (1) ein inneres Tragwerk (5) und wenigstens ein Tragwerkverbindungsmittel (6) aufweist, wobei das innere Tragwerk (5) innerhalb des Gehäusekörpers (2) angeordnet ist, das eine oder die mehreren Tragwerkverbindungsmittel (6) die Wandung (7) des Gehäusekörpers (2) durchdringen, das eine oder die mehreren Tragwerkverbindungsmittel (6) das innere Tragwerk (5) mit dem äußeren Tragwerk (4) verbinden und die elektrischen Einrichtungen (3) an dem inneren Tragwerk (5) befestigt sind.

2. Schaltschrank (1) für ein Pitchsystem nach Anspruch 1, **dadurch gekennzeichnet, dass** die Wandung (7) des Gehäusekörpers (2) zwischen innerem Tragwerk (5) und äußerem Tragwerk (4) eingeklemmt ist.

3. Schaltschrank (1) für ein Pitchsystem nach einem der Ansprüche 1 bis 2, **dadurch gekennzeichnet, dass** das innere Tragwerk (5) wenigstens eine Montageplatte (8) aufweist, wobei die elektrischen Einrichtungen (3) mittelbar oder unmittelbar an der einen oder den mehreren Montageplatten (8) befestigt sind.

4. Schaltschrank (1) für ein Pitchsystem nach einem der Ansprüche 1 bis 3, **dadurch gekennzeichnet, dass** wenigstens um den Bereich der einen oder wenigstens einer der mehreren Durchdringungen der Wandung (7) des Gehäusekörpers (2) jeweils eine Dichtung (10) zwischen dem äußeren Tragwerk (4) und der Wandung (7) des Gehäusekörpers (2) angeordnet ist.

5. Schaltschrank (1) für ein Pitchsystem nach einem der Ansprüche 1 bis 4, **dadurch gekennzeichnet, dass** der Schaltschrank (1) wenigstens ein Verbindungsmittel (9) aufweist, wobei das eine oder die mehreren Verbindungsmittel (9) die Wandung (7) des Gehäusekörpers (2) durchdringen und das eine oder die mehreren Verbindungsmittel (9) das innere Tragwerk (5) mit dem Gehäusekörper (2) verbinden.

6. Schaltschrank (1) für ein Pitchsystem nach einem der Ansprüche 1 bis 5, **dadurch gekennzeichnet, dass** der Schaltschrank (1) eine Öffnung (11) und einen korrespondierenden Deckel (12) aufweist, wobei die Öffnung (11) lösbar mit dem Deckel (12) verschließbar ist.

7. Schaltschrank (1) für ein Pitchsystem nach Anspruch 6, **dadurch gekennzeichnet, dass** das äußere Tragwerk (4) an der Außenseite der der Öffnung (11) gegenüberliegenden Seite (7) des Gehäusekörpers (2) angeordnet ist.

8. Schaltschrank (1) für ein Pitchsystem nach einem der Ansprüche 1 bis 7, **dadurch gekennzeichnet, dass** zwischen dem inneren Tragwerk (5) und der Wandung (7) des Gehäusekörpers (2) wenigstens ein Innenprofilträger (13) angeordnet ist, wobei der eine oder die mehreren Innenprofilträger (13) an die innere Form der Wandung (7) des Gehäusekörpers (2) angepasst sind.

9. Schaltschrank (1) für ein Pitchsystem nach Anspruch 8, **dadurch gekennzeichnet, dass** das eine oder die mehreren Tragwerkverbindungsmittel (6) den einen oder wenigstens einen der mehreren Innenprofilträger (13) durchdringen und der eine oder die mehreren Innenprofilträger (13) zwischen dem Gehäusekörper (2) und dem inneren Tragwerk (5) eingeklemmt sind.

10. Schaltschrank (1) für ein Pitchsystem nach einem der Ansprüche 8 bis 9, **dadurch gekennzeichnet, dass** der eine oder wenigstens einer der mehreren Innenprofilträger (13) ein L-Profil aufweist und jeweils zumindest teilweise entlang einer Innenkante der inneren Wandung (7) des Gehäusekörpers (2) verlaufen.

11. Schaltschrank (1) für ein Pitchsystem nach einem der Ansprüche 1 bis 10, **dadurch gekennzeichnet, dass** das äußere Tragwerk (4) wenigstens zwei Profilträger (14) aufweist.

12. Schaltschrank (1) für ein Pitchsystem nach Anspruch 11, **dadurch gekennzeichnet, dass** das innere Tragwerk (5) wenigstens eine Querstrebe (15) aufweist, wobei die eine oder wenigstens eine der mehreren Querstreben (15) mit wenigstens zwei der Profilträger (11) über das eine oder wenigstens eines der mehreren Tragwerkverbindungsmittel (6) verbunden ist.

13. Schaltschrank (1) für ein Pitchsystem nach einem der Ansprüche 11 bis 12, **dadurch gekennzeichnet, dass** wenigstens zwei der Profilträger (14) im Wesentlichen parallel zueinander verlaufen.

14. Schaltschrank (1) für ein Pitchsystem nach einem der Ansprüche 11 bis 13, **dadurch gekennzeichnet, dass** wenigstens zwei der Profilträger (14) im Wesentlichen senkrecht zueinander verlaufen.

15. Schaltschrank (1) für ein Pitchsystem nach einem der Ansprüche 11 bis 14, **dadurch gekennzeichnet, dass** die Formen der Profilträger (14) des äußeren Tragwerks (4) ausgewählt sind aus der Gruppe bestehend aus I-Profil, L-Profil, T-Profil, U-Profil und Z-Profil.
